Europäisches Patentamt

European Patent Office

Office européen des brevets

(11) Veröffentlichungsnummer: **0 289 012**
**A2**

## (12) EUROPÄISCHE PATENTANMELDUNG

(21) Anmeldenummer: 88106783.9

(22) Anmeldetag: 27.04.88

(51) Int. Cl.⁴: **H01S 3/06 , H01S 3/19 ,**
**H01L 31/18**

(30) Priorität: 30.04.87 DE 3714522

(43) Veröffentlichungstag der Anmeldung:
02.11.88 Patentblatt 88/44

(84) Benannte Vertragsstaaten:
DE FR GB

(71) Anmelder: **Siemens Aktiengesellschaft Berlin**
**und München**
**Wittelsbacherplatz 2**
**D-8000 München 2(DE)**

(72) Erfinder: **Amann, Markus-Christian, Dr.-Ing.**
**Unterhachinger Strasse 6**
**D-8000 München 83(DE)**
Erfinder: **Baumann, Gerhard G., Dr. rer. nat.**
**Friedenstrasse 6**
**D-8012 Ottobrunn(DE)**
Erfinder: **Thulke, Wolfgang, Dr. rer. nat.**
**Neubiberger Strasse 38**
**D-8000 München 83(DE)**

(54) **Verfahren zur Herstellung einer Laserdiode mit vergrabener aktiver Schicht.**

(57) Bei der Herstellung von Laserdioden mit streifenförmiger aktiver Schicht entsteht beim Aufbringen seitlicher Schichten (5, 6, 7), insbesondere sperrender p-n-Übergänge zur seitlichen Stromführung, das Problem, daß diese Schichten (5, 6) oberhalb der aktiven Schicht (2) unerwünscht sind. Durch Aufbringen einer schützenden Deckschicht (4), die die Eigenschaft hat, sich in unterkühlten Schmelzen aus dem Material der seitlichen Schichten (5, 6, 7) zu lösen, vor dem Aufwachsen der seitlichen Schichten (5, 6, 7), wird das Aufwachsen der seitlichen Schichten (5, 6), insbesondere sperrender p-n-Übergänge, oberhalb des aktiven Streifens (2) vermieden, da sich die Deckschicht (4) beim epitaktischen Aufbringen der seitlichen Schichten (5, 6, 7) in der Schmelze löst.

FIG 4

## Verfahren zur Herstellung einer Laserdiode mit vergrabener aktiver Schicht

Die Erfindung betrifft ein Verfahren zur Herstellung einer Laserdiode mit vergrabener aktiver Schicht.

Es ist bekannt, Laserdioden mit niedrigen Schwellenströmen und hoher Ausgangsleistung als Laserdiode mit Doppelheteroschichtstruktur und vergrabener aktiver Schicht herzustellen (siehe z. B. G. Winstel, C. Weyrich, Optoelektronik 1, Springer Verlag, Berlin, Heidelberg, New York 1980, Seite 225 bis 232). Dabei wird die aktive Schicht in Form eines Streifens in ein Halbleitermaterial eingebettet, das einen geringeren Brechungsindex und eine größere Energiebandlücke als das Material der aktiven Schicht hat. Durch die unterschiedlichen Einsatzspannungen der Homo-p-n-Übergangs seitlich der aktiven Schicht und des Hetero-p-n-Übergänge der aktiven Schicht fließt der Strom im wesentlichen über die aktive Schicht. Es ist zweckmäßig, diese seitliche Stromführung dadurch zu verbessern, daß seitlich der aktiven Schicht mindestens je ein sperrender p-n-Übergang angeordnet wird. Diese sperrenden p-n-Übergänge werden gewöhnlich in einem zweiten Epitaxieprozeß eingebaut, wobei das Verfahren so zu gestalten ist, daß oberhalb des aktiven Laserstreifens kein solcher sperrender Übergang erhalten wird. Es ist bekannt, das Wachstum eines sperrenden Übergangs auf dem aktiven Streifen zu verhindern durch Aufbringen von maskierenden Schichten wie z. B. SiO₂ oder durch die Wahl des Profils des aktiven Streifens, wobei ausgenutzt wird, daß auf bestimmten Kristallflächen oder bei bestimmten Verhältnissen von Höhe und Breite des Streifens kein Kristallwachstum auf dessen Oberfläche erfolgt. Eine weitere Möglichkeit ist, den sperrenden p-n-Übergang zunächst auch über dem aktiven Streifen aufzuwachsen und ihn dann durch selektive Diffusion wieder leitend zu machen. Maskierende Schichten wie z. B. SiO₂ müssen in einem gesonderten Arbeitsgang wieder gelöst werden. Die Unmöglichkeit des Kristallwachstums auf bestimmten Kristallflächen und Streifenformen -schränkt die Wahl des Streifenprofils ein. Die selektive Diffusion macht zusätzliche Verfahrensschritte notwendig.

Der Erfindung liegt die Aufgabe zugrunde, eine weiteres, verbessertes Verfahren zur Vermeidung unerwünschter Schichten oberhalb der aktiven Schicht bei der Herstellung von Laserdioden mit vergrabener aktiver Schicht anzugeben.

Die Aufgabe wird mit einem Verfahren nach dem Oberbegriff des Anspruchs 1 erfindungsgemäß gelöst, wie dies im kennzeichnenden Teil des Anspruch 1 angegeben ist.

Das Verfahren hat den Vorteil, daß es auf jeder Kristallfläche und jedem Streifenprofil anwendbar ist und die Zahl der Verfahrensschritte gering hält.

Weitere Ausgestaltungen der Erfindung gehen aus den Unteransprüchen hervor.

In den FIG 1 bis 6 ist ein Ausführungsbeispiel dargestellt. Es wird im folgenden näher erläutert.

FIG 1 stellt eine Lasergrundstruktur dar, die eine Doppelheteroschichtstruktur und eine Deckschicht enthält.

In FIG 2 ist eine Lasergrundstruktur dargestellt, auf der durch seitliches Abätzen ein Streifen definiert wurde.

FIG 3 zeigt eine Lasergrundstruktur nach dem Aufwachsen der ersten Schicht seitlich des Streifens.

FIG 4 zeigt eine Lasergrundstruktur nach dem Aufwachsen der zweiten Schicht seitlich des Streifens.

FIG 5 zeigt eine Laserdiode ohne Kontaktierung.

FIG 6 zeigt eine Laserdiode mit Isolatorschichten zur seitlichen Stromführung und Metallkontakten.

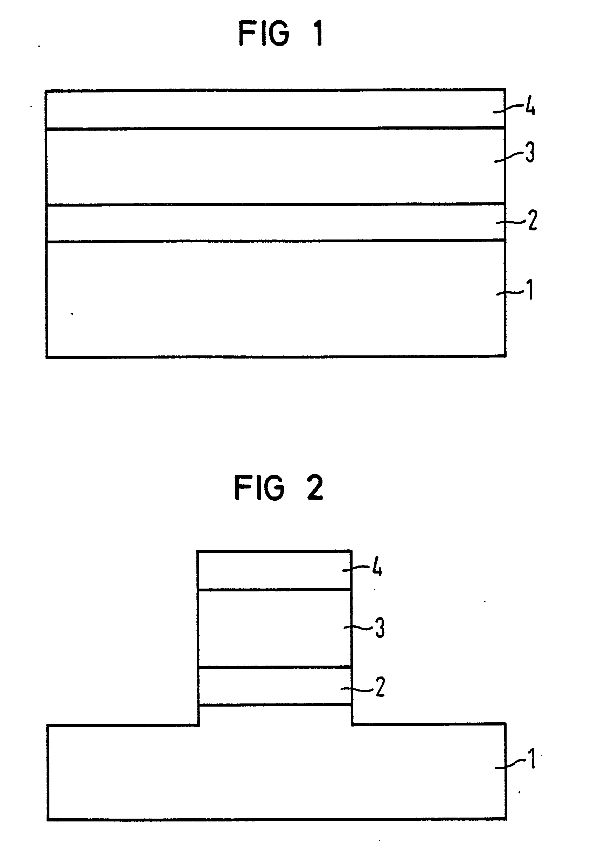

Auf ein Substrat 1 aus einem ersten Halbleitermaterial, z. B. InP, eines ersten Leitfähigkeitstyps, z. B. n-leitend, wird eine aktive Schicht 2 eines zweiten Halbleitermaterials, z. B. InGaAsP, aufgebracht. Das zweite Halbleitermaterial hat einen größeren Brechungsindex und eine geringere Energiebandlücke als das erste. Auf die aktive Schicht 2 wird eine obere Schicht 3 aus dem ersten Halbleitermaterial, z. B. InP, eines zweiten Leitfähigkeitstyps, z. B. p-leitend, aufgewachsen. Auf die obere Schicht 3 wird eine Deckschicht 4 aus einem dritten Halbleitermaterial, z. B. In$_{1-x}$Ga$_x$As$_y$P$_{1-y}$ mit $1 \geq x \geq 0,35$, $1 \geq y \geq 0$, , aufgebracht. Das dritte Halbleitermaterial hat die Eigenschaft, daß es sich in unterkühlten Schmelzen des ersten Halbleitermaterials löst (FIG 1).

Durch seitliches Abätzen der Deckschicht 4, der oberen Schicht 3 und der aktiven Schicht 2 bis in das Substrat 1 wird die Streifenform der aktiven Schicht 2 definiert (FIG 2).

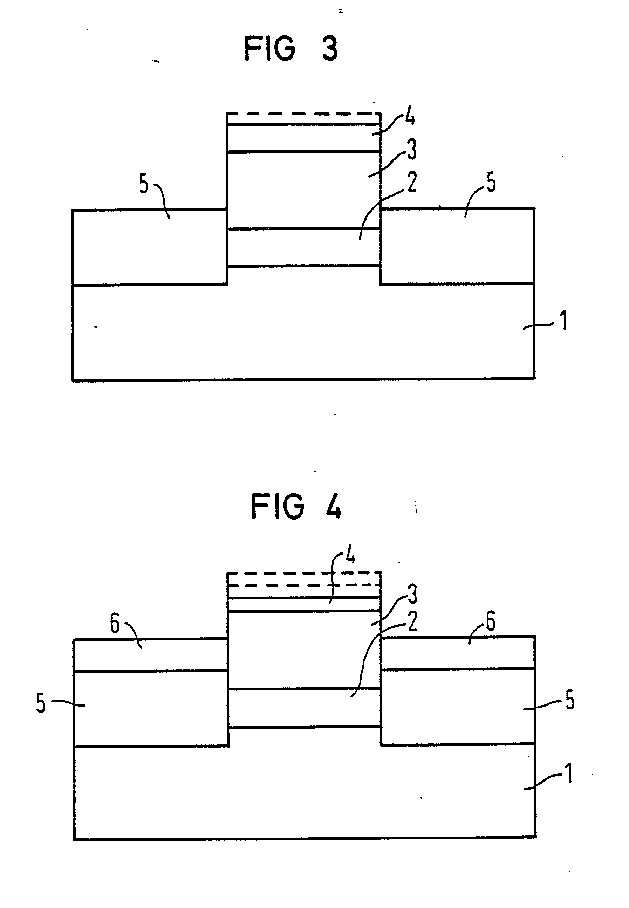

Seitlich des Streifens wird eine erste Halbleiterschicht 5 des ersten Halbleitermaterials, z. B. InP, des zweiten Leitfähigkeitstyps, z. B. p-leitend, epitaktisch aufgebracht. Da das Material der Deckschicht 4 so gewählt ist, daß es sich in unterkühlten Schmelzen des ersten Halbleitermaterial löst, wird beim Aufbringen der ersten Halbleiterschicht 5 die Deckschicht 4 teilweise rückgelöst (FIG 3).

Seitlich des Streifens wird auf die erste Halbleiterschicht 5 eine zweite Halbleiterschicht 6 aus dem ersten Halbleitermaterial, z. B. InP, des ersten Leitfähigkeitstyps, z. B. n-leitend, aufgebracht. Dabei wird die Deckschicht 4 weiter rückgelöst (FIG 4). Der erste und der zweite Leitfähigkeitstyp sind so gewählt, daß sich im Betrieb der Laserdiode an der Grenzfläche zwischen der ersten Halbleiterschicht 5 und der zweiten Halbleiterschicht 6 ein sperrender p-n-Übergang ausbildet.

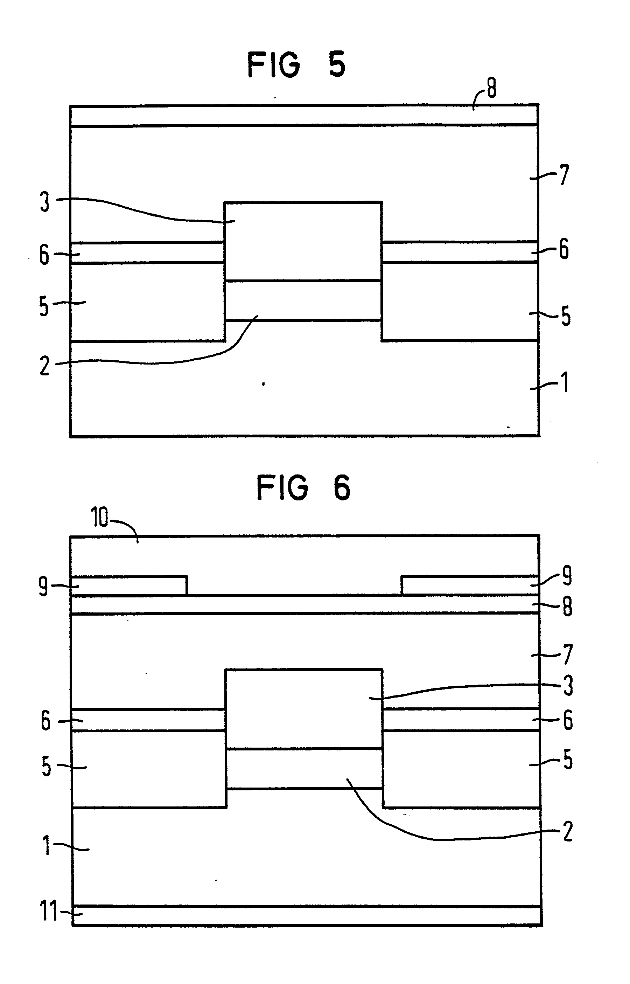

Seitlich des Streifens wird auf die zweite Halbleiterschicht 6 eine dritte Halbleiterschicht 7 aus dem ersten Halb leitermaterial, z. B. InP, des zweiten Leitfähigkeitstyps, z. B. p-leitend, aufgebracht. Dabei wird der Rest der Deckschicht 4 vollständig gelöst. Die dritte Halbleiterschicht 7 wächst ganzflächig auf der Scheibe auf (FIG 5).

Für Kontaktierungszwecke ist es vorteilhaft, eine vierte Halbleiterschicht 8 aus dem zweiten Halbleitermaterial, z. B. InGaAsP, vom zweiten Leitfähigkeitstyp, z. B. p-leitend, aufzubringen. Die vierte Halbleiterschicht 8 erfüllt die Aufgabe, den Übergangswiderstand bei der Kontaktierung der Laserdiode zu verringern. Die vierte Halbleiterschicht 8 wird ganzflächig auf der dritten Halbleiterschicht 7 aufgewachsen (FIG 5).

Um die seitliche Stromführung weiter zu verbessern, wird seitlich des Streifens eine Isolatorschicht 9 aufgebracht. Auf die Isolatorschicht 9 und die freiliegende vierte Halbleiterschicht 8 wird ein Metallkontakt 10 aufgebracht. Der Metallkontakt 10 ist nur im Bereich des Streifens leitend mit der vierten Halbleiterschicht 8 verbunden, da außerhalb des Streifens der Metallkontakt 10 durch die Isolatorschicht 9 von der vierten Halbleiterschicht 8 getrennt ist. Dadurch ist schon die Strominjektion auf den Bereich der streifenförmigen aktiven Schicht 2 begrenzt (FIG 6).

Die dem Schichtaufbau abgewandte Seite des Substrats 1 wird mit einem Metallkontakt 11 versehen.

## Ansprüche

1) Verfahren zur Herstellung einer Laserdiode mit vergrabener aktiver Schicht und mit Metallkontakten auf den gegenüberliegenden Seiten des Schichtaufbaus, das von einer Doppelheteroschichtstruktur ausgeht, die mindestens ein Substrat aus einem ersten Halbleitermaterial, eine aktive Schicht aus einem zweiten Halbleitermaterial, das einen größeren Brechungsindex und eine geringere Energiebandlücke als das erste Halbleitermaterial hat, und eine obere Schicht aus dem ersten Halbleitermaterial enthält, **gekennzeichnet** durch folgende Schritte:

a) auf die Doppelheteroschichtstruktur wird auf die obere Schicht (3) eine Deckschicht (4) aufgebracht aus einem dritten Halbleitermaterial, das die Eigenschaft hat, sich in unterkühlten Schmelzen des ersten Halbleitermaterials zu lösen,

b) durch seitliches Abätzen der Deckschicht (4), der oberen Schicht (3) und der aktiven Schicht (2) bis in das Substrat (1) wird ein Streifen definiert,

c) durch Flüssigphasenepitaxie werden seitlich des Streifens mindestens bis zur Höhe des Streifens Schichten (5, 6, 7) aus dem ersten Halbleitermaterial aufgebracht, wobei sich die Deckschicht (4) löst.

2) Verfahren nach Anspruch 1, dadurch **gekennzeichnet,** daß als erstes Halbleitermaterial InP verwendet wird und daß als drittes Halbleitermaterial $In_{1-x}Ga_xAs_yP_{1-y}$ insbesondere mit $x \geq 0{,}35$ verwendet wird.

3) Verfahren nach Anspruch 1 oder 2, dadurch **gekennzeichnet,** daß seitlich des Streifens eine Schichtfolge mit solchen Dotierungen aufgebracht wird, daß sich im Betrieb der Laserdiode beiderseits des aktiven Streifens (2) Sperrschichten ausbilden.

4) Verfahren nach einem der Ansprüche 1 bis 3, dadurch **gekennzeichnet,** daß beim Aufbringen der seit lichen Schichten (5, 6, 7) die Scheibe mit einer Schicht (7) überwachsen wird.

5) Verfahren nach einem der Ansprüche 1 bis 4, dadurch **gekennzeichnet,** daß zur Verbesserung des Übergangswiderstands des Metallkontakts (10) an der dem Substrat (1) abgewandten Seite des Schichtaufbaus unter dem Metallkontakt (10) eine Schicht (8) des zweiten Halbleitermaterials aufgebracht wird.

6) Verfahren nach einem der Ansprüche 1 bis 5, dadurch **gekennzeichnet,** daß zur Verbesserung der seitlichen Stromführung seitlich des Streifens der aktiven Schicht (2) unter dem Metallkontakt (10) an der dem Substrat (1) abgewandten Seite des Schichtaufbaus eine Isolatorschicht (9) aufgebracht wird.

# FIG 1

# FIG 2

## FIG 3

## FIG 4

## FIG 5

## FIG 6